# EUROPEAN PATENT APPLICATION

(11) **EP 1 923 973 A1**
(43) Date of publication of application: **21.05.2008**
(21) Application number: 06782560.4
(22) Date of filing: 09.08.2006
(51) Int. Cl.: H01S 5/22, H01S 5/343

(54) **HIGH-POWER RED SEMICONDUCTOR LASER**

(30) Priority: 12.08.2005 JP 2005234658
(71) Applicant: ROHM CO., LTD., Kyoto-shi, Kyoto 615-8585 (JP)
(72) Inventor: NAKAHARA, Ken c/o Rohm Co., Ltd., Kyoto-shi, Kyoto 6158585 (JP); ISHIKAWA, Tsutomu c/o Rohm Co., Ltd., Kyoto-shi, Kyoto 6158585 (JP)
(74) Representative: TBK-Patent
(86) International application number: PCT/JP2006/315744
(87) International publication number: WO 2007/020852

(57) **Abstract**

Provided is a high-power red semiconductor laser having a laser element in which a temperature rise is suppressed with improved heat dissipation characteristics thereof, and which accordingly needs not be enlarged in heat dissipation area. An n-AlGaInP cladding layer (3), an AlGaInP optical guide layer (4), an MQW active layer (5), an AlGaInP optical guide layer (6), a p-AlGaInP first cladding layer (7), an AlGaInP etching stop layer (8), an n-AlGaInP block layer (11), a p-AlGaAs second cladding layer (9), a p-GaAs contact layer (10) and a p-electrode (12) are stacked on the top surface of a tilted n-GaAs substrate (2). An n-electrode (1) is formed on the back surface of the n-GaAs substrate (2). The heat dissipation characteristics of the laser element are improved, because the second cladding layer (9) contains AlGaAs, which has a higher heat conductivity.

## Description

### BACKGROUND OF THE INVENTION

### 1. Field of the Invention

The present invention relates to a high-power red semiconductor laser which is used for a digital versatile disc (DVD) or the like.

### 2. Description of the Related Art

Development in the market of recordable DVDs has led to a demand that AlGaInP red semiconductor lasers each with a waveband of 650 nm should output a high power of more than 250 mW.

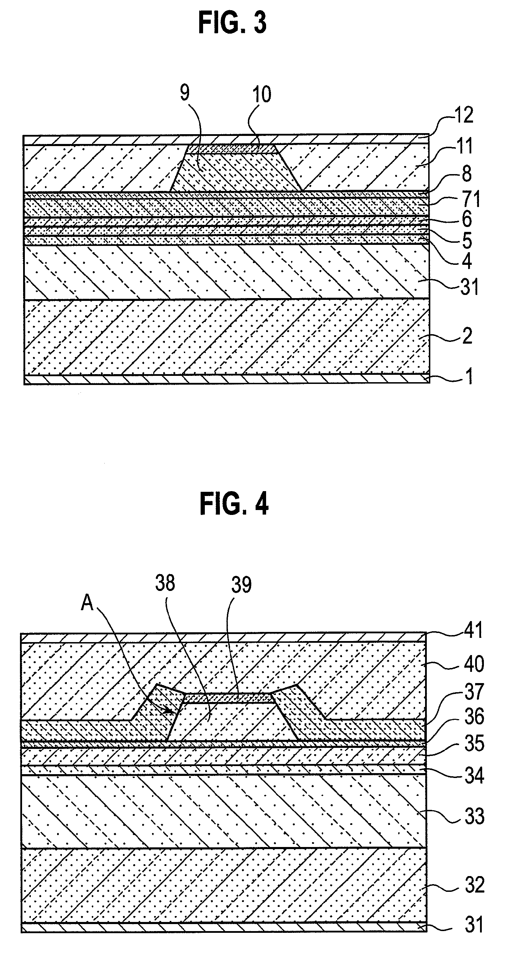

Fig. 4 shows a generally-used configuration of this type of red semiconductor laser. The red semiconductor laser includes an n-GaAs substrate 32 and a semiconductor laminated structure grown on the substrate 32. On the substrate 32, the semiconductor laminated structure includes an n-AlGaInP cladding layer 33, a multiple quantum well (MQW) active layer 34, a p-AlGaInP first cladding layer 35, a p-GaInP etching stop layer 36, an n-GaAs block layer 37, a p-AlGaInP second cladding layer 38, a p-GaInP buffer layer 39, and a p-GaAs cap layer 40 in this sequence. In addition, an n-electrode 31 is formed on the bottom surface of the n-GaAs substrate 32, and a p-electrode 41 is formed on the top surface of the p-GaAs cap layer 40.

The red semiconductor laser shown in Fig. 4 has an embedded ridge structure. In the embedded ridge structure, the second cladding layer 38 and the buffer layer 39 form a stripe-shaped ridge part A, the n-GaAs block layer 37 is arranged on the two sides of this ridge part A, and the p-GaInP buffer layer 39 and the n-GaAs block layer 37 are covered with the p-GaAs cap layer 40.

A light beam is confined in the horizontal direction by use of the difference between the refractive index of the ridge part A and the refractive index of the n-GaAs block layer 37 arranged on the sides of the ridge part A. The electrical current flows into the stripe-shaped ridge part A, but not into the reversely biased n-GaAs block layer 37 or below the layer 37.

In addition, if the p-GaAs cap layer 40 is directly joined to the p-AlGaInP second cladding layer 38, the flow of an electrical current is obstructed. This is because a large bandgap difference between the layer 40 and the layer 38 creates, around the joining interface, a large barrier against holes as carriers in the p-side region, thereby obstructing the holes' flow. For the purpose of preventing this problem, the p-GaInP buffer layer 39 is interposed between the p-GaAs cap layer 40 and the p-AlGaInP second cladding layer 38. The p-GaInP buffer layer 39 has a bandgap intermediate between those of the two layers 40 and 38. This lowers the barrier created around the bonding interface so that the holes can easily to flow through.

When an electrical current flows from the p-electrode 41 to the n-electrode 31, the electrical current is constricted by the n-GaAs block layer 37 as a current blocking layer, and a light beam is accordingly emitted from a center portion of the MQW active layer 34. Here, the center portion corresponds to a location under the ridge part A. If a high power of more than 250 mW is intended to be obtained, it is necessary to increase the operating current. The increase in the operating current leads to increase in Joule's heat caused due to the electrical resistance in each layer, and accordingly generates a larger amount of heat in the laser element.

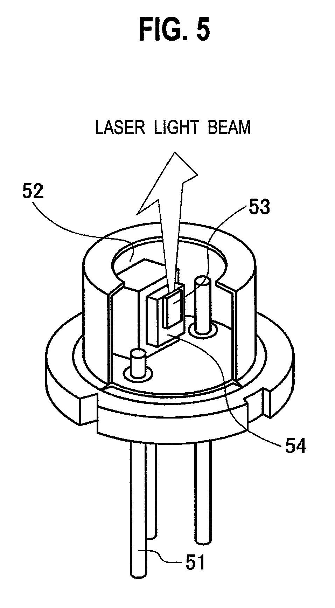

For the purpose of preventing the temperature from rising due to the heat generation in a semiconductor laser element which is built as a module, the following technique is disclosed in Japanese Patent Application Laid-open Publication No. Hei. 9-205249. In this technique, a laser element 53 built as a module is designed, as shown in Fig. 5, to be cooled by being mounted on a heat sink 54 attached to a package configured of an optical glass window 52, lead pins 51, and the like.

### SUMMARY OF THE INVENTION

In the case of the conventional type of red semiconductor laser, when the amount of heat generated in the laser element becomes larger as a result of increase in Joule' heat, the heat tends to be accumulated particularly in the laser element due to the poor heat conductivity of AlGaInP used as the basic material of the laser element. The heat accumulation raises the temperature of the laser element excessively. As a result, the luminous efficiency and the maximum output power of the laser element are decreased. In addition, the configuration where, as shown in Fig. 5, the laser element is designed to be cooled by use of the heat sink has a problem that the laser element with poor heat dissipation characteristics cannot be cooled sufficiently. This is because the cooling capability of the heat sink has its limit.

Hence, a conceivable method for facilitating the dissipation of the heat from the laser element may be to increase the heat dissipation amount from the laser element by enlarging the surface area thereof. In general, the improvement of the temperature characteristics of the laser element requires the current density therein to be lowered. Accordingly, the length of the resonant cavity is set as long. For this reason, if the dissipation area of the laser element is intended to be enlarged, the length of the laser element needs to be further enlarged in a direction in which the resonant cavity extends (in the axial direction).

However, the laser element constructed in the foregoing manner can be considerably large and thus very expensive. In addition, because the package on which a laser element is going to be mounted as shown in Fig. 5 is usually produced in a certain size, if the laser element is built longer and larger than this package, this brings about a problem that the laser element is incapable of being mounted on the package.

The present invention has been made for the purpose of solving the foregoing problems. An object of the present invention is to provide a high-power red semiconductor laser having a laser element in which a temperature rise is suppressed with improved heat dissipation characteristics thereof, and which accordingly needs not be enlarged in heat dissipation area.

To achieve the foregoing object, a first aspect of the present invention is characterized as follows. In an AlGaInP-type high-power red semiconductor laser including at least an n- type cladding layer, an active layer and a p-type cladding layer in this sequence on an n-type semiconductor substrate, as well as a stripe-shaped ridge part which includes the p-type cladding layer above the active layer, semiconductor layers constituting the ridge part is partially formed of a semiconductor containing AlGaAs.

A second aspect of the present invention is the high-power red semiconductor laser according to the first aspect, characterized in that the p-type cladding layer is formed of a semiconductor containing AlGaAs.

A third aspect of the present invention is the high-power red semiconductor laser according to the first aspect, characterized in that, the p-type cladding layer is separated into a second p-type cladding layer including the ridge part and a first p-type cladding layer not including the ridge part by an etching stop layer formed in the middle of the p-cladding layer.

A fourth aspect of the present invention is the high-power red semiconductor laser according to the third aspect, characterized in that the second p-type cladding layer is formed of a semiconductor containing AlGaAs.

A fifth aspect of the present invention is the high-power red semiconductor laser according to the fourth aspect, characterized in that the first p-type cladding layer is formed of a semiconductor containing AlGaAs.

A sixth aspect of the present invention is the high-power red semiconductor laser according to any one of the first to fifth aspects, characterized in that the n-type cladding layer is formed of a semiconductor containing AlGaAs.

According to the present invention, a part of the semiconductor layers constituting the ridge part, for example, the p-type cladding layer, is formed of the semiconductor containing AlGaAs, which has a higher heat conductivity. For this reason, the heat generated in the laser element easily conducts to the p-electrode, and easily radiate from the p-electrode. This makes it possible to prevent the laser element from rising in temperature excessively.

By forming the cladding layer with the semiconductor containing AlGaAs, which has the high heater conductivity, the heat dissipation characteristics of the laser element can be enhanced. This makes it unnecessary that the heat dissipation area of the laser element should be enlarged.

### BRIEF DESCRIPTION OF THE DRAWINGS

Fig. 1 is a diagram showing a cross-sectional structure of a high-power red semiconductor laser according to the present invention.
Fig. 2 is a diagram showing another cross-sectional structure of the high-power red semiconductor laser according to the present invention.
Fig. 3 is a diagram showing yet another cross-sectional structure of the high-power red semiconductor laser according to the present invention.
Fig. 4 is a diagram showing a cross-sectional structure of a conventional type of red semiconductor laser.
Fig. 5 is a diagram showing a configuration of a package to which the semiconductor laser is attached.

### DESCRIPTION OF THE PREFERRED EMBODIMENTS

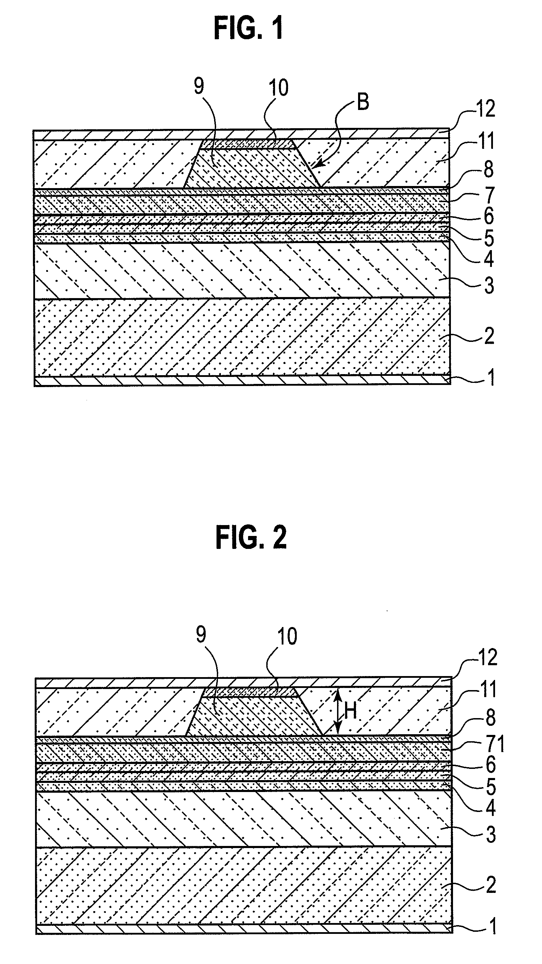

Description will be provided hereinbelow for embodiments of the present invention with reference to the drawings. Fig. 1 shows a cross-sectional structure of a high-power red semiconductor laser according to the present invention.

An n-AlGaInP cladding layer 3, an AlGaInP optical guide layer 4, an MQW active layer 5, an AlGaInP optical guide layer 6, a p-AlGaInP first cladding layer 7, an AlGaInP etching stop layer 8, an n-AlGaInP block layer 11, a p-AlGaAs second cladding layer 9, a p-GaAs contact layer 10 and a p-electrode 12 are stacked on the top surface of a tilted n-GaAs substrate 2. An n-electrode 1 is formed on the back surface of the n-GaAs substrate 2. An n-GaAs material whose crystal orientation is tilted at an angle of 10 to 15 degrees from the (001)-plane is used for the n-GaAs substrate 2.

The MQW active layer 5 is formed of three GaInP well layers and two undoped (Al_{0.5}Ga_{0.5})_{0.5}In_{0.5}P barrier layers. The n-AlGaInP cladding layer 3 is formed of (Al_{0.7}Ga_{0.3})_{0.5}In_{0.5}P doped with n-type impurity Si. The AlGaInP optical guide layer 4 and the AlGaIP optical guide layer 6 are each formed of undoped (Alo_{0.5}Ga_{0.5})o.₅In_{0.5}P. The p-AlGaInP first cladding layer 7 is formed of (Al_{0.7}Ga_{0.3}) _{0.5}In_{0.5}P doped with p-type impurity Zn. The AlGaInP etching stop layer 8 is formed of three unstrained (Al_{0.1}Ga_{0.9}) _{0.5}In_{0.5}P layers doped with p-type impurity Zn and two (Al_{0.4}Ga_{0.6}) _{0.5}In_{0.5}P layers doped with p-type impurity Zn by alternately stacking them on each other. The p-AlGaAs second cladding layer 9 is formed of Al_{0.5}GaAs doped with p-type impurity Zn. The p-GaAs contact layer 10 is formed of GaAs doped with p- type impurity Zn. The n-AlGaInP block layer 11 is formed of (Al_{0.8}Ga_{0.2})0.5In_{0.5}<P doped with n-type impurity Si. A multilayered metal film consisting of Ti films and Au films is used for the p-electrode 12. An alloy layer containing Au, Ge and Ni as well as a multilayered metal film consisting of Ti films and Au films is used for the n-electrode 1.

The MQW active layer 5 is interposed between the AlGaInP optical guide layers 4 and 6. These optical guide layers are formed to confine a light beam in the vertical direction. Adjusting the composition and thickness of each of the optical guide layers makes it possible to control a vertical spread angle of the light beam. When the light beam is loosely confined in the vertical direction, the light emitting spot is enlarged in the vertical direction. As a result, the vertical spread angle of the emitted light beam (the size of the far field pattern (FFP) in the layer-stacking direction) decreases.

The high-power red semiconductor laser shown in Fig. 1 has an embedded-ridge structure. In the embedded-ridge structure, the p-AlGaAs second cladding layer 9 and the p-GaAs contact layer 10 form a stripe-shaped ridge part B, and the two sides of the ridge part B are covered with the n-AIGaInP block layer 11. The electrical current flows into the stripe-shaped ridge part B, but not into the reversely biased n-AlGaInP block layer 11 or below the layer 11.

The high-power red semiconductor laser according to the present invention is manufactured as follows by metal organic chemical vapor deposition (MOCVD), photolithographic technique and the like, which are publicly known. It should be noted that the film thickness appropriate for each layer varies in accordance with the composition ratio of a semiconductor material used for the layer, and the like. In the present embodiment, each layer is formed with the following thickness in accordance with the aforementioned composition ratio thereof.

Through a first round of crystal growth by MOCVD, the n-AlGaInP cladding layer 3 with a thickness of 2.5 µm, the AlGaInP optical guide layer 4 with a thickness of 3.5 nm, the MQW active layer 5, the AlGaInP optical guide layer 6 with a thickness of 10 nm, the p-AlGaInP first cladding layer 7 with a thickness of 0.24 µm, the AlGaInP etching stop layer 8, the p-AlGaAs second cladding layer 9 with a thickness of 1.25 µm and the p-GaAs contact layer 10 with a thickness of 0.2 µm are sequentially formed on the n-GaAs substrate 2. Thereby, a double heterostructure wafer is obtained. The MQW active layer 5 has a multiple-quantum-well structure including three well layers each with a thickness of 6 nm and two barrier layers each with a thickness of 4 nm. The etching stop layer 8 has a multilayered structure including three unstressed (Al_{0.1}Ga_{0.9}) _{0.5}In_{0.5}P layers each with a thickness of 2 nm and two (Al_{0.4}Ga_{0.6}) _{0.5}In_{0.5}P layers each with a thickness of 5 nm.

Subsequently, by using a stripe-shaped SiO₂ as a mask, the p-GaAs contact layer 10 and the p-AlGaAs second cladding layer 9 are etched by dry etching. Thereby, the ridge part B is formed. Thereafter, the ridge part B is etched by wet etching by use of a solution of hydrochloric acid or a dilute solution of sulfuric acid and a solution of hydrogen peroxide until the etching reaches the etching stop layer 8. The ridge etching is automatically stopped by the etching stop layer 8, and the ridge part is thus formed in a well-controlled manner.

After that, the wafer is returned into the MOCVD apparatus, where the n-AlGaInP block layer 11 is formed on the wafer through the second round of crystal growth. Subsequently, the SiO₂ mask is removed through a hydrofluoric acid (HF) process. Finally, the resultant wafer is thinned down to a thickness of approximately 100 µm by lapping and polishing, and the n-electrode 1 and p-electrode 12 are formed on the resultant wafer by vacuum deposition.

Once an electrical current is flowed from the p-electrode 12 to the n-electrode 1, an oscillation starts, and a laser light beam is generated continuously. At this time, a large amount of Joule's heat is generated particularly in the p-side layers and the MQW active layer 5 due to electrical resistances of the layers and the like. The heat thus generated diffuses therefrom, and rapidly conducts through the second cladding layer 9 to reach the p-GaAs contact layer 10. This is because the second cladding layer 9 solely contains AlGaAs, which has a higher heat conductivity. The heat diffusing through the p-GaAs contact layer 10 quickly reaches the p-electrode 12 because the p-GaAs contact layer 10 is thin. The heat consequently dissipates from the p-electrode 12. In the high-power red semiconductor laser according to the present invention, heat generated therein diffuses more quickly than in the red semiconductor laser shown in Fig. 4, because AlGaAs has a heat conductivity approximately twice as high as AlGaInP. As described above, the heat dissipation characteristics of the laser element in the high-power red semiconductor laser is improved by forming the semiconductor layers constituting the ridge part B partially with a semiconductor containing AlGaAs, and this improvement can prevent the laser element from rising in temperature excessively.

Incidentally, the heat conductivity of AlGaAs mixed crystal can be increased (the heat resistance thereof can be decreased) by lowering its Al composition ratio. However, the cladding layer formed of AlGaAs with a low Al composition ratio would have a too little bandgap energy to block minority carriers from draining away. For this reason, the Al composition ratio of the cladding layer should be preferably 40% to 70%, and more preferably 50% to 60%, like in the present embodiment. In the present embodiment, the cladding layer is formed of Al_{0.5}GaAs where an Al composition ratio is 50%.

Fig. 2 shows a structure which is the same as the structure shown in Fig. 1 except that the p-AlGaInP first cladding layer 7 is replaced with a p-AlGaAs first cladding layer 71. The first cladding layer 71 is formed of Al_{0.5}GaAs doped with p-type impurity Zn as similar to the second cladding layer 9. Because the heat conductivity of AlGaAs is high as described above, Joule' s heat generated in the MQW active layer 5 and the p-side layers rapidly conducts through the p-AlGaAs first cladding layer 71, and also rapidly diffuses through the p-AlGaAs second cladding layer 9 to reach the p-electrode 12. Accordingly, the laser element has improved heat dissipation characteristics. In addition, it is desirable that the heat diffusion distance should be shortened by lowering the height H of the ridge part B for the purpose of further improving the heat dissipation characteristics of the laser element. The same holds for the configurations respectively shown in Figs. 1 and 3.

Fig. 3 shows a structure which is the same as the structure shown in Fig. 3 except that the n-AlGaInP cladding layer 3 is replaced with an n-AlGaAs cladding layer 31. The cladding layer 31 is formed of Al_{0.5}GaAs doped with n-type impurity Si. This structure is intended to cause Joule's heat generated in the n-side layers to similarly dissipate efficiently by forming the cladding layer 31 of a semiconductor containing AlGaAs, which has a higher heat conductivity. The heat generated in the n-side layers rapidly conducts through the n-AlGaAs cladding layer 31 so that the heat easily diffuses to reach the p-electrode 12 and the n-electrode 1. As a result, the heat dissipation characteristics of the laser element are improved.

It should be noted that the film thickness of each layer is not limited to that described with regard to the embodiments. It suffices, for example, that the n-cladding layers 3 and 31 are approximately 1 µm to 3 µm in thickness; the n-side optical guide layer 4, 5 nm to 30 nm; each well layer constituting the MQW active layer 5, approximately 3 nm to 9 nm; each barrier layer constituting the MQW active layer 5, approximately 3 nm to 9 nm; the p-side optical guide layer 6, 5 nm to 30 nm; the p-type first cladding layer 7 and 71, 0.2 µm to 0.4 µm; each unstrained (Al_{0.1}Ga_{0.9})_{0.5}In_{0.5}P layer constituting the etching stop layer 8, approximately 1 nm to 5 nm; each (Al_{0.4}Ga_{0.6})_{0.5}In_{0.5}P layer constituting the etching stop layer 8, approximately 3 nm to 10 nm; the p-type second cladding layer 9, in a range of 0.5 µm to 2 µm, more desirably 0.8 µm to 1.5 µm; and the p-type contact layer 10, 0.2 µm to 0.8 µm.

## Claims

1. An AlGaInP-based high-power red semiconductor laser including: at least an n-type cladding layer, an active layer and a p-type cladding layer in this sequence on an n-type semiconductor substrate; and a stripe-shaped ridge part including the p-type cladding layer above the active layer,
the AlGaInP-based high-power red semiconductor **characterized in that** semiconductor layers constituting the ridge part is partially formed of a semiconductor containing AlGaAs.

2. The high-power red semiconductor laser according to claim 1, **characterized in that** the p-type cladding layer is formed of a semiconductor containing AlGaAs.

3. The high-power red semiconductor laser according to claim 1, **characterized in that** the p-type cladding layer is separated into a second p-type cladding layer including the ridge part and a first p-type cladding layer not including the ridge part by an etching stop layer formed in the middle of the p-type cladding layer.

4. The high-power red semiconductor laser according to claim 3, **characterized in that** the second p-type cladding layer is formed of a semiconductor containing AlGaAs.

5. The high-power red semiconductor laser according to claim 4, **characterized in that** the first p-type cladding layer is formed of a semiconductor containing AlGaAs.

6. The high-power red semiconductor laser according to any one of claims 1 to 5, **characterized in that** the n-type cladding layer is formed of a semiconductor containing AlGaAs.
